# EUROPEAN PATENT SPECIFICATION

(11) **EP 2 606 003 B1**
(45) Date of publication and mention of the grant of the patent: **23.06.2021**
(21) Application number: 11751678.1
(22) Date of filing: 15.08.2011
(51) Int. Cl.: C01B 3/24, C01B 3/28, H01J 37/32, H05H 1/46

(54) **AN APPARATUS, A SYSTEM AND A METHOD FOR PRODUCING HYDROGEN**
VORRICHTUNG, SYSTEM UND VERFAHREN ZUR HERSTELLUNG VON WASSERSTOFF
APPAREIL, SYSTÈME ET PROCÉDÉ POUR PRODUIRE DE L'HYDROGÈNE

(30) Priority: 17.08.2010 NO 20101156
(43) Date of publication of application: 26.06.2013
(73) Proprietor: Gasplas AS, 0218 Oslo (NO)
(72) Inventor: RISBY, Phillip John, Norfolk NR14 8PE (GB)
(74) Representative: Onsagers AS
(86) International application number: PCT/NO2011/000224
(87) International publication number: WO 2012/023858

(56) References cited:
- EP-A1- 1 936 656
- EP-A2- 0 461 683
- WO-A1-2007/042559
- WO-A1-2007/086875
- WO-A1-2010/094972
- DE-A1- 4 414 083
- US-A1- 2003 024 806
- None

## Description

### Field of the invention

The invention relates to the field of hydrogen production. In particular, but not exclusively, the invention relates to a device for producing hydrogen using microwave-generated plasma, and an associated method of producing hydrogen.

### Background of the invention

With the current focus on reducing harmful emissions from industrial plants, buildings, cars and other vehicles caused by their combustion of hydrocarbons, there has been much research into developing alternative energy sources, such as hydrogen.

Whilst the adoption of alternatives to hydrocarbon fuels offers the opportunity for a more environmentally-friendly vehicle, the process by which such alternative fuels are produced remains far from ideal. Hydrogen for example is currently synthesised by the catalytic cracking of hydrocarbon molecules. The high temperatures required for this reaction to take place are achieved usually by burning oil or coal, resulting in the emission of further environmental pollutants. Also, the process of generating hydrogen by electrolysis of water consumes more energy than is stored in the produced hydrogen. If the consumed electricity is produced from hydrocarbon sources, the overall result is even worse for the environment. Thus, current commercial hydrogen production processes are considered to generate a higher volume of harmful greenhouse gases per useful energy quota of hydrogen than direct combustion of the fuel that the hydrogen is intended to replace. In other words, currently hydrogen is not a clean fuel when its production is taken into account.

Therefore, there is a need to develop a process capable of producing hydrogen with high efficiency and significantly lower environmental impact than is currently available. Ideally such a process would be highly flexible in that it should readily admit to operation on small, medium and large commercial scale. One method that offers the potential to generate hydrogen at lower environmental costs than existing commercial systems utilises plasma processing. In plasma processing, hydrogen containing gases or liquids are input to a chamber in which they are ionised to form a plasma, for example by exposure to a high intensity field. In the plasma state the constituents of the feed material are dissociated and may either be extracted separately, recombined or reacted with additional feed materials, depending on the required output product. Plasma processing also offers significant advantages and unique capabilities in, for example, the areas of cracking, dissociation and deposition (including diamond deposition and fabrication of activated products) as well as gas polishing.

Various forms of plasma are known to exist, generally categorised by their energy and density characteristics: principally thermal plasmas (also referred to a equilibrium plasmas) and non-equilibrium plasmas (also referred to as non-thermal, or cold, plasmas). This latter group includes those produced by RF, induction, barrier discharge, microwave and laser excitation. Electromagnetic-induced plasmas, in particular, offer the potential for highly efficient cracking of both gas and liquid feed materials due to superior energy coupling between energy source, plasma and feedstock. Such plasmas have been shown to have a catalytic effect, as a result of coupling between the electromagnetic, particularly microwave, field and the feed material, that increases the rate of reaction, which in turn reduces the time for which the feed material must be maintained in the plasma state, i.e. the residency time.

Microwaves are generally taken to refer to electromagnetic radiation with wavelength in the range 1 m to 1 x 10⁻² m. Electromagnetic radiation outside this range can still generate plasma effectively but microwave sources represent a mature technology as they have long been used in the fields of radar and microwave ovens and in industrial food preparation. Hence microwave sources of suitable power levels are readily available for domestic and industrial heating purposes.

There is however a problem in scaling up reaction chambers that use microwaves generated for commercial plasma operations. Thus, whilst microwave plasmas offer an ideal route to facilitating chemical reactions and processes these have, to date, only been carried out on a relatively small scale and only as a batch process.

Microwave-generated plasma sources can be divided into two groups: those that operate at low pressure (typically below 10⁻¹ bar and which produce low density plasmas suitable for surface cleaning and activation applications), and those that operate at around atmospheric pressure and above, producing high intensity plasma suitable for cracking and chemical reactions/synthesis applications. Any commercial system that can be used for fuel dissociation is preferably based on a 'high-pressure' system, which permits higher throughput of feed fluids, shorter residency times and relatively compact process equipment, thus offering effective and energy-efficient production of end products. Further, the considerable differences in pressure that can occur in a low-pressure system make the adoption of a low-pressure system impractical for continuous operation and/or commercial applications.

Two prior types of atmospheric plasma generator are known: low volume single tube and higher volume single magnetron. Whilst reactors based on both types have had some success on the laboratory scale, no design has yet proved sufficiently flexible for operation on a commercial scale. Those of the former type are limited in size by the dimensions of the waveguide required to contain the exciting radiation. That is, the waveguide limits the size of the plasma. A fundamental limit in reactor tube diameter is thus set by the frequency of the microwave source, which limits application to lab-scale devices. Those of the latter type rely on a resonator cavity to generate localised regions of high-intensity electromagnetic fields, which in turn generate and sustain the plasma. High microwave power is therefore required, both to generate the plasma and to supply sufficient energy to the feed material for processing. Device size is again limited by microwave source frequency and power as the reaction chamber is required to be resonant. Both microwave frequency and the power at which it is generated therefore limit the potential chamber size of a reactor based on either of these operational principles.

Whilst it is relatively straightforward to combine AC, DC, RF and HF plasmas to generate more plasma for processing, this has not hitherto proved possible to any significant extent with microwave plasmas. The difficulties associated with phase-locking microwave sources to increase the plasma volume in a reactor chamber are well known and well documented. There are a number of technologies for RF electromagnetic energy generation that can be frequency and phase controlled. In order to provide the necessary phase locking for multiple plasma sources to combine additively, RF generators can be fine-tuned to ensure that they all operate at the same phase and frequency. Microwave generators such as a magnetron or Klystron do not have readily adjustable phase and frequency characteristics. The power, frequency, phase and size of the resonator are all interrelated and it is simply not possible to adjust one without adversely affecting the contribution of another. Moreover, magnetrons and Klystrons emit microwaves in a frequency band about a fundamental value. Significant components exist outside the fundamental frequency and these can be magnified enough to feed back into and damage the microwave source. Isolators may be used to protect the source but together phase locking and isolators add considerable cost and reduce the available microwave energy. Practically, magnetron phase-locking has been achieved but only for very few sources, under very limited conditions and with considerable complexity.

One example of a device for the production of a plasma using microwaves is described in US 6,204,603. This device makes use of a coaxial resonator into which microwaves are coupled. An electromagnetic standing-wave pattern is established in the resonator, which, at regions of high-intensity (amplitude), is sufficient to generate the plasma. However, the use of a resonant chamber in this device limits the potential volume of plasma that can be generated at one time.

A large area plasma generator is described in JP2006/156100. This document describes the use of a number of individual microwave antennas to generate plasma within a common space in order to achieve a more uniform distribution of plasma within that space. Although the antennas are separate, they are driven by a single, common microwave source to ensure all of the plasma sources (antennas) are in phase, thereby also limiting the maximum power to the plasma. The document clearly illustrates the difficulties and complexities involved in maintaining a plasma region using multiple microwave plasma sources.

US 2003/024806 A1 discloses a "Plasma Jet Vortex Mill Reactor" comprising a plurality of plasma torches tangentially aligned on the reactor's cylindrically wall and the use of said reactor in the treatment of wastes and exhaust gases like VOCs.

It is an object of this invention to provide an improved device and method for plasma utilisation employing microwave electromagnetic radiation.

It is a further object of the present invention to provide a plasma-generating device that is not subject to the restrictions to the volume of microwave-generated plasma that can be generated and maintained simultaneously to which prior art devices are subject.

A still further object of the present invention is to provide a microwave plasma generator in which the volume and / or power of plasma produced has reduced dependence on the characteristics of the source used in its generation in comparison to conventional plasma reactors.

A still further object of the present invention is to provide a system and a method of producing hydrogen by utilizing a microwave plasma generator.

### Summary of the invention

The invention is set forth and characterized in the main claims, while the dependent claims describe other characteristics of the invention.

It is provided a system for producing hydrogen from gaseous hydrocarbon, **characterised by** a gas pre-treatment module (2) fluidly connected to a gas reservoir (66) and to at least one hydrogen generator (100); and a hydrogen post-processing module (3) fluidly connected via a feeding conduit (81) to the generator and to a storage and distribution module (5), said hydrogen generator comprising plasma nozzles (105); a reaction chamber (102) coupled to each of the plasma nozzles; each plasma nozzle comprising a microwave plasma generator (301, 302) and a feed tube (303) for directing a flow of the gaseous hydrocarbon via the plasma generator to respective inlets to the reaction chamber, whereby the microwave plasma generator is suitable for at least partly ionising the gaseous hydrocarbon to form a plasma prior to entry of the at least partly ionised hydrocarbon into the reaction chamber, and the reaction chamber comprises at least one outlet (101) via which hydrogen is conveyed to the post-processing module (3), and the pre-treatment module (2) comprises means for pre-heating the gaseous hydrocarbon.

In one embodiment, the post-processing module comprises means for cooling the hydrogen, preferably a heat exchanger.

In one embodiment, the system further comprises a conduit and a medium for transporting the heat extracted from the gas by said means for cooling, to a location upstream of the hydrogen generator, where the medium is heat exchanged with the gaseous hydrocarbon prior to its entry into the hydrogen generator.

The system advantageously comprises a feed-back conduit fluidly connected to the feeding conduit and adapted for feeding at least a portion of the hydrogen back to hydrogen generator.

In one embodiment, the storage and distribution module comprises hydrogen compressor and boosting means, hydrogen storage means and hydrogen output means. A carbon reservoir is preferably connected via a conduit to the hydrogen generator.

An apparatus suited for being used in the system for producing hydrogen from a gas comprising hydrocarbon, is characterised by means for connection to a supply of gaseous hydrocarbon; plasma nozzles coupled thereto and a reaction chamber in fluid communication with each of the plasma nozzles; each plasma nozzle comprising a microwave plasma generator and a feed tube for directing a flow of the gaseous hydrocarbon via the plasma nozzles to respective inlets to the reaction chamber, whereby the plasma nozzles at least partly ionises gaseous hydrocarbon to form a plasma prior to entry of the at least partly ionised hydrocarbon into the reaction chamber, and the reaction chamber comprises at least one outlet via which hydrogen is collected, whereby hydrogen may be produced continuously and without the generation of oxides of carbon.

In one embodiment, the plasma nozzles are adapted to encourage a plasma stabilising flow within the feed tube and the plasma nozzles are adapted to encourage stabilising flow by shaping of the feed tube therein.

In one embodiment, the plasma nozzles are adapted to encourage stabilising flow by incorporation of an agitating element within the feed tube. The plasma stabilising flow may be a vortex.

The reaction chamber has in one embodiment curved side walls.

In one embodiment, the feed tube comprises an input port for reactants such as substrate particles downstream from the plasma generator, the input port being arranged such that the flow of reactant material into the feed tube supports the maintenance of the plasma stabilising flow within the feed tube.

The nozzle and its inlet to the reaction chamber are in one embodiment coaxially aligned with the reaction chamber whereby an additional stabilising flow is established within the reaction chamber.

In one embodiment, the coupling of the plasma nozzles to the reaction chamber is adapted to establish an additional stabilising flow in the reaction chamber. The direction of the output of each plasma nozzle is orientated to input feed materials to the reaction chamber at an acute angle to the circumferential wall of the reaction chamber. The additional stabilising flow may be a vortex.

In one embodiment, a fixed or moving layer of a substrate material is provided within the reaction chamber for the separation and collection of one or more components of the plasma reaction.

The additional stabilising flow is capable of supporting particulate suspension within the reaction chamber.

Advantageously, the particulate suspension is used in the separation and collection of one or more components of the plasma reaction within the reaction chamber.

In one embodiment, the plasma generator of each nozzle is powered by a magnetron.

Preferably, the reaction chamber is non-resonant with respect to the plasma generator.

In one embodiment, the outlet extends an adjustable length into the chamber.

The apparatus comprises in one embodiment a secondary chamber in fluid communication with the reaction chamber, said secondary chamber having an exit port.

In one embodiment, one or more electrostatic collectors are arranged within the secondary chamber, and the exit port is fluidly connected to a powder precipitator and/or a powder collector.

The reaction chamber comprises in one embodiment an input channel which is adapted for a secondary flow of one or more reactants, and further comprises means for selectively feeding particles from the lower output port to the input channel and further into the reaction chamber.

In one embodiment, the apparatus further comprising an atomising or vaporising device, prior to the plasma generator for atomising or vaporising the feed material.

It is also provided a method of producing hydrogen from a gas comprising hydrocarbon, characterised by the steps of:
a) feeding separate quantities of the gas at a controlled pressure to respective regions where each quantity of gas is subjected to a respective electromagnetic field, whereby a non-equilibrium plasma at atmospheric pressure and above is generated in each region;
b) feeding the separate quantities of plasma into a reaction chamber via separate inlets while controlling the flow properties of the plasma in order to sustain the plasma and maintain it in an ionised state until it enters the reaction chamber and for a duration of time thereafter; and
c) extracting produced hydrogen via an outlet from the reaction chamber, whereby hydrogen may be produced virtually on demand, continuously and without the generation of oxides of carbon, and the respective plurality of electromagnetic fields are generated by separate and individual microwave sources, and
d) extracting precipitated carbon from the reaction chamber.

In one embodiment, the method further comprises the mixing of said separate quantities of plasma in the reaction chamber while the plasmas are in an ionised state.

In one embodiment, the controlling of the flow properties of the plasma in step b) comprises forming a vortex gas flow before the gas enters the plasma state.

In one embodiment, a substrate in particulate form is introduced into the plasma in the reaction chamber, and the substrate does in one embodiment comprise precipitated carbon extracted from the reaction chamber.

A system constructed in accordance with this invention has numerous advantages over the prior art. Most importantly, with the present invention higher volumes of microwave-generated plasma at atmospheric pressure and above may be generated and this plasma and the associated afterglow be collected simultaneously in a single volume, in contrast to previously available plasma generation, which makes the system and the plasma generation method particularly suited to commercial scale processing operations and enables improved efficiencies to be achieved in plasma processing operations, such as in the production of hydrogen. This set-up allows electromagnetic isolation of the plasma generators from each another, which in turn ensures that their risk of damage by mutual interference is markedly reduced. The plasma and afterglow generated by such sources is additive as it collects in the reaction chamber which permits control of the end product formations. This is achieved without the need for phase locking, which proved a severe limiting factor to the prior art.

A system constructed in accordance with this invention is considerably more flexible than plasma reactors known in the prior art as a result of the reaction chamber being spatially separate from the plasma source. The same reactor can be readily adapted to suit different processes, which may be run continuously if desired.

As stated previously, the accepted range for microwave radiation is wavelengths in the range 1 m to 1 x 10⁻² m. It is preferred that microwaves used to generate plasma in accordance with this invention are in the range 0.5 m to 0.05 m. The location of the reaction chamber remote from the plasma generator allows multiple plasma-generating sources to be used in which their output is additive. That is, the volume of plasma and/or the afterglow produced, and hence available for process reactions, increases with the number of sources. This is in direct contrast to the prior art in which a fundamental limitation is provided by the characteristics of the generating microwave radiation itself: with conventional plasma reactors, the chamber must be resonant to this radiation or it must generate a waveguide limited region around the plasma, the waveguide function in turn limiting the size to one that is dictated by microwave frequency.

Scaling up prior art processes for microwave plasma generation, such as those described in US 6,204,603 and JP2006/156100, to a commercial scale is not known to have been achieved and is simply not feasible with previously available technology. Single-tube processes are restricted to low volume because of the need to form a waveguide at the surface of the plasma. It is not feasible to generate more plasma using such a process by extending it to multiple microwave sources. The sources would need to be synchronised in frequency and phase, which is difficult to achieve but, more fundamentally, the volume of plasma would still be limited by the dimensions of the waveguide: multiple sources would result in a more intense plasma for more energy-intensive processing but not more processing plasma *per* se. Single-magnetron processes, as described in US 6,204,603, rely on the reaction chamber being resonant with respect to a suitable mode of the microwave radiation. In this way localised regions of high-intensity fields can be produced within the chamber, which are sufficient to excite and sustain the plasma on timescales sufficient to allow a desired reaction to take place. The requirement for the chamber to be resonant to one of a limited number of modes necessarily means that its size is dictated by the frequency of the microwave source. It is accordingly impossible to scale such a device up and down for a given excitation frequency.

As mentioned above, in the present invention the plasma-generating region is remote from the reaction chamber. The minimum separating distance between a plasma-generating region and the reaction chamber is the minimum distance necessary to ensure electromagnetic isolation of the individual microwave fields of the plasma nozzles. The maximum separating distance is dependent upon the persistence of the plasma state which, in turn, is dependent upon at least the energy of the plasma, the velocity and stabilisation of the feed flow, and the desired reactions and recombinations as determined by position within the plasma/afterglow. Preferably, the separating distance is between 0.005 m and 1 m, more preferably between 0.05 m and 0.5 m, more preferably still between 0.02 m and 0.2 m. The minimum separation is partially dependent upon the wavelength of electromagnetic radiation employed.

Ideally, the plasma generated in accordance with the present invention is induced to flow in a stabilising pattern, which extends its existence beyond the plasma generation sites and so enables collection of the plasma in the reaction chamber. The fluid flow within the reaction chamber also enables delineation of a 'reaction zone' within the chamber within which the majority of the required reactions take place. Predominantly, it is the plasma afterglow that persists in the collection chamber, the afterglow being that region in which plasma is sustained by mechanisms other than the generating excitation. Such persistence is believed to be assisted by the stabilising flow.

With the plasma sources remote from a common chamber and by transferring and combining plasma plumes in the common chamber in which reactions can take place, with the reactant(s) persisting in a plasma state, this invention offers huge flexibility in fundamental aspects of plasma processing. In particular, the dissociation stage of the plasma process occurs at a location that is physically separate from the recombination stage of the reaction process and isolated from the environment in which dissociation occurs. This allows different process conditions to be established for each stage. This, in turn, permits ideal conditions for recombination to be set in the reaction chamber in order to encourage the desired reaction / recombination. Flexibility is therefore offered both in the potential for scaling up and down the size and output of the reactor vessel and in the type and range of chemical and physical reaction processes that can be performed in the reaction chamber.

Unlike prior art plasma chambers that combine multiple phase-locked microwave plasma generators, with the present invention there is no restriction on the number of microwave plasma generators that may be coupled to the one collection chamber in excess of two. The only practical limit is that of the size of the collection chamber and the physical dimensions of the coupling of a plasma nozzle to the collection chamber i.e. the number of plasma nozzles that can be physically fitted around the chamber. In some applications the number of plasma nozzles may be limited by the need to establish particular gas flow characteristics within the reaction chamber. With the particular embodiments described herein preferably at least four plasma generators are coupled to a single reactor chamber.

The total plasma generation inputted to the collection chamber can be from 1 KW to several MW depending upon the application and is a function of the number of plasma nozzles used.

The term "plasma nozzle" should be understood herein to encompass any device fitted with an energizing source (e.g. a magnetron) that is capable of directing feed fluids from an input port through a plasma-generating region or zone to an output port.

The plasma nozzle may be adapted to encourage stabilising flow in the collection chamber by defining a guidance tube therein. For example, the design of the nozzle may be based on a vortex tube in which lateral inputs lead to an output gas flow with a strong vortex motion. Alternatively, the nozzles may comprise an agitating element within the tube, for example, a spiral impeller or fan.

Ideally, the nozzle adaptation to encourage stabilising flow is located upstream of the plasma generator. This arrangement has the added advantage of increasing the exposure of the feed material to the plasma zone which, in turn, leads to more uniformity in processing.

The stabilising flow is most preferably a vortex flow, by which it is meant that the gases undergo a generally helical flow, of decreasing radius. It is known that vortex flow can stabilise plasma to some degree, but it has not hitherto been appreciated that such stabilising mechanism can have the surprising benefits of flexibility in the design of reaction vessels, as described herein.

Alternatively, or in addition, the plasma reactor may be further adapted to encourage an additional stabilising flow inside the collection chamber. This additional stabilising flow may be encouraged by the flow characteristics of the stabilising flow in the nozzles and / or by means of the arrangement of plasma nozzles around the collection chamber and / or their manner of coupling to the chamber. The nozzles may be coupled to the chamber so as to input feed materials / plasma to the chamber at an angle to the chamber walls, preferably a tangential angle. The additional stabilising flow may also be a vortex flow. Alternative flow inducers, separate from the nozzles, are also envisaged such as an agitating element within the reaction chamber.

Preferably, the reaction chamber has curved side walls. For example, the chamber may be cylindrical, toroidal or even spherical in shape. This, in combination with the stabilising flow, has great potential for improvement across a huge range of chemical and physical processes. In the first instance, the plasma plumes / afterglow will extend out of the nozzle outlet into the reaction chamber and be shaped by the flow pattern to extend laterally alongside the reaction chamber wall. Feed, collection or substrate particles, or other reactant materials that flow around the chamber will then have an increased residency time in an afterglow environment, as the afterglow from successive nozzles is encountered. This allows more complete plasma processing and therefore improved reaction efficiency. If the plasma nozzles are sufficiently close and / or the plumes persist for sufficient time, these individual plumes may merge to form a continuous plasma torus within the chamber.

Another advantage provided by the flow conditions within the chamber is that ready separation of reaction products may, in many cases, be enabled. For example, if carbon and hydrogen are the reaction products, the carbon may be allowed to cluster and drop under gravity whereas the hydrogen flow may be directed upwards. Exits at or near the top and bottom of the chamber therefore allow these products to be removed as the plasma generation and the reaction in the reaction vessel continues. That is, product removal is facilitated without stopping the reaction process. The potential for continuous running significantly improves productivity.

In another embodiment, the stabilising flow may be capable of supporting a belt of particles in suspension within the chamber. These particles may then act as a substrate for one or more of the reaction products, which assists in their separation and removal from the chamber. Again, this permits continuous operation of the reaction vessel as opposed to a batch process, which was hitherto the only means of operation of such reaction vessels.

The reaction vessel or collection chamber of the present invention is not limited by the type of plasma that is used. Each plasma nozzle may comprise a low-volume source or a large-volume resonant source, or indeed any other suitable microwave plasma source. Indeed, in addition to the microwave plasma sources the reaction vessel may have other non-microwave plasma sources and plasma nozzles. It is considered beneficial, for likely commercial applications however, to operate at atmospheric pressure and above. A preferred operating range is 0.01 - 8 bar, although higher operating pressures (e.g. 10 to 25 bar) can be envisaged.

Specifically, with the present invention the plasma source of each nozzle is preferably derived using a magnetron as the microwave source. Each nozzle comprises a feed tube through which feed materials flow and each magnetron may comprise at least one waveguide dimensioned for microwave radiation and arranged to intersect the feed tube at or near a position at which the electric field of the microwave radiation is most intense. Such a design is simple to implement and, in fact, such microwave sources are readily and cheaply available.

In the preferred embodiment of this invention the feed tube comprises a swirl inducer located at or near the intersection of the feed tube with the magnetron waveguide. This ensures that the stabilising (preferably vortex) flow is induced prior to plasma generation which ensures better mixing of the feed materials with the plasma, which in turn ensures better processing.

As stated previously, the accepted range for microwave radiation is wavelengths in the range 1 m to 1 x 10⁻² m. Using current, easily available devices it is preferred that microwaves used to generate plasma in accordance with this invention have device wavelengths in the range 0.5 m to 0.05 m.

The microwave plasma generator employed in the plasma nozzle is preferably a coaxial magnetron. The energy supplied to the microwave generator of each plasma nozzle is preferably between 0.1 kW and 500 kW, more preferably 0.5 kW to 120 kW, most preferably 1 kW to 75 kW.

In a preferred embodiment each of the plasma nozzles of the plasma reactor has a microwave plasma generator. However, it is also envisaged that the plasma reactor may comprise a range of different plasma sources connected to the collection chamber some of which may not be microwave plasma generators. It is most preferred that none of the microwave plasma generators of the plasma reactor are phase locked but more generally no more than a minority of the microwave plasma generators connected to a common reaction chamber may be phase locked.

The flow of material through the plasma nozzle preferably comprises a fluid, more preferably a gas. Furthermore, the flow through the plasma-generating zone of the plasma nozzle preferentially contains one or more reactants. Depending upon the process reaction, preferably a major part, or ideally all, of at least one of the reactants flows through the plasma-generating zone. The reactants may constitute more than 50% of the flow through the plasma-generating zone, more preferably more than 75% of the flow and most preferably more than 90% of the flow.

The fluid fed to the plasma nozzle is preferably at a temperature of between -20 °C and +600 °C, more preferably 0 °C to 200 °C, most preferably 50 °C to 150 °C.

The pressure within the plasma nozzle is preferably from 0.01 bar abs. to 8 bar abs., more preferably from 0.3 bar abs. to 5 bar abs., most preferably from 0.8 bar abs. to 3 bar abs.

The average residence time within the plasma nozzle may be 10⁻⁶ seconds to 10⁻¹ seconds, but preferably 2x10⁻⁶ seconds to 10⁻² seconds. It will be understood though that the average residence time is dependent upon the material being ionised. As an example, the specific energy consumed to completely crack methane passing through the microwave plasma generator of the present invention at 100% efficiency is around 23 kJ/mol.

Whilst the volume of the reactor chamber in each case will be dependent upon the intended application and the processing requirements of the plasma reactor, in the case of a 2.45 GHz microwave plasma generator exemplary ranges of volumes are 10⁻³ m³ to 10³ m³, more preferably 10⁻² m³ to 10² m³, most preferably 1.5 m³ to 10² m³. The volume of the reaction chamber should be no less than 5 x 10⁻⁴ m³ per nozzle per KW but may extend upwards from this without limitation.

The residency time within the reaction chamber is dependent upon the reaction(s) occurring within the chamber and the desired output product but may extend from 0.1 seconds to several hours.

The reaction chamber (otherwise referred to herein as the afterglow chamber or the collection chamber) ideally comprises an exit channel that extends through an upper wall of the chamber, and which is preferably centrally located. The exit channel may extend a pre-selected or adjustable length into the chamber. The exit channel acts as a collection point for gaseous output(s) from the reaction chamber. Its height within the chamber can be adjusted to collect a particular gas product. Also, within the exit channel a number of smaller tubes may be fitted internally in such a manner as to encourage the vortex motion to remain in the reaction chamber and not to dissipate with exhaust gas outflow.

The provision of one or more exits from the reaction chamber enables the reaction products to be extracted without stopping or interfering with plasma generation. That is, without affecting the continuous running of the process. Product removal is also desirable to prevent it clogging up the system (for example, in a carbon-generation process) or to release a build-up of pressure (for example in a hydrogen or other gas-production process).

The plasma reactor may further comprise a secondary chamber in fluid communication with the reaction chamber. The secondary chamber may also comprise an exit port. In a preferred embodiment the secondary chamber is located below the reaction chamber. Such a lower port is ideally placed for extracting solid products from the chamber. Moreover, a secondary vortex may be drawn through this exit port, oriented centrally within the chamber, in order to entrain a reaction product for collection. In order to prevent gas escaping the lower exit port, the port may be fitted with a gas-restricting valve.

A collection aid such as an electrostatic collector, powder precipitator or polymer-forming substrate may be included within or in fluid communication with either or both of the upper and lower chambers. These provide further possible means to collect an output product depending upon the nature of the reaction taking place within the reaction chamber. For example, an electrostatic plate or ring will attract solids, encouraging their separation from a gas flow.

So as to enable the introduction of substrates or other materials for product collection, the reaction chamber may further comprise an input channel along which a secondary flow may be passed. Alternatively, other materials may be input into the reaction chamber via one or more of the plasma nozzles which may or may not be actively generating plasma at that time.

The plasma reactor may also comprise one or more atomising or vaporising devices to enable liquids to be processed in this invention. The atomising or vaporising devices may be located at a plasma nozzle or at an inlet to the reaction chamber.

### Brief description of the drawings

These and other characteristics of the invention will be clear from the following description of a preferential form of embodiment, given as a non-restrictive example, with reference to the attached drawings wherein:
Figure 1 is a block diagram illustrating an embodiment of the system and method in accordance with the invention;
Figure 2 is a schematic illustration of an embodiment of a reaction vessel used in the invention;
Figures 3a and 3b are schematic illustrations of electrostatic devices arranged in the lower chamber, for collecting outputs products in a particulate or pulverised state;
Figure 4a is a schematic illustration of a powder precipitator and collector device, arranged in fluid communication with the lower output port;
Figure 4b is a schematic illustration of an arrangement for feeding precipitated powder from the lower output port and into the upper region of the reaction chamber;
Figures 5a and 5b are schematic illustrations of alternative embodiments of the invention, showing different arrangements of plasma nozzles about the reaction chamber;
Figure 6 illustrates schematically an example of an apparatus of a plasma-generating region, suitable for incorporation in the nozzles;
Figure 7 illustrates schematically a second example of an apparatus of a plasma-generating region, suitable for use with this invention;
Figure 8 is a schematic illustration of a component of the plasma nozzle, shaped so as to direct feed gases in a vortex motion through the plasma-generating region;
Figure 9 is a schematic illustration of an alternative component within the plasma nozzle, shaped so as to direct feed gases in a vortex motion through the plasma-generating region;

### Detailed description of embodiments

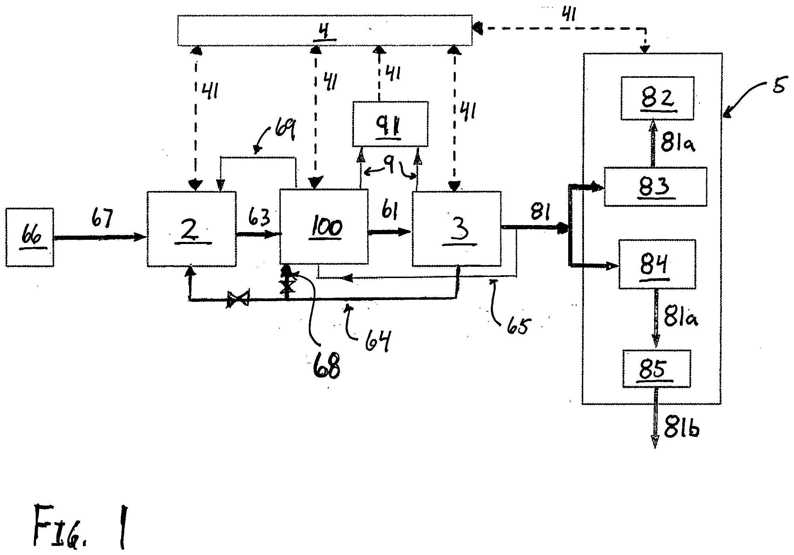

Referring initially to figure 1, the system according to the invention comprises generally a plasma reactor 100, pre- and post-processing modules 2, 3, and a storage and distribution module 5. The operation of the modules within the system is controlled by a control and monitoring module 4, via communication lines 41.

A hydrocarbon gas, preferably a natural gas such as methane, is fed from a reservoir 66 via a feed line 67, into the pre-processing module 2. The reservoir 66 may be a suitable vessel near or in the vicinity of the pre-processing module, or may comprise a gas supply line connected to a distal source.

In the pre-processing module 2, the gas is subjected to scrubbing, drying and separation in a manner which per se is known in the art, before being fed into the plasma generator 100 via feed line 63.

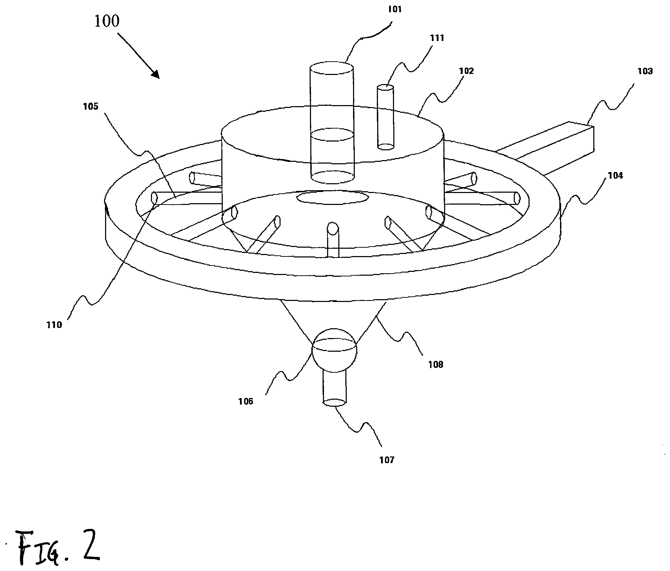

Figure 2 shows, in overview, an embodiment of a plasma reactor 100 in accordance with the present invention. The plasma reactor 100 comprises an input channel 103 through which feed gases flow to an annular manifold 104. A plurality of plasma nozzles 105 connects the manifold 104 to a reaction chamber 102. In one specific construction (not shown in figure 2), four plasma nozzles of 35 mm diameter are used. A greater or lesser number of nozzles than the number illustrated are also possible, as are diameters within the range 25 mm to 50 mm. The reaction chamber 102 could advantageously in this construction have a diameter of 500 mm, but this diameter could be in the range of for example 250 mm to several meters, depending on the desired scale of production

Within each plasma nozzle 105, the feed gases may selectively and controllably be excited to form plasma at a plasma-generating zone or region, a process which is explained later. In each plasma nozzle, the minimum separating distance between a plasma-generating region and the inlet to the reaction chamber (i.e. the nozzle outlet) is the minimum distance necessary to ensure electromagnetic isolation of the individual microwave fields of the plasma nozzles. The maximum separating distance is dependent upon the persistence of the plasma state which, in turn, is dependent upon at least the energy of the plasma, and the velocity and stabilisation of the feed flow. Preferably, the distance separating the plasma-generating region from the reaction chamber in each nozzle is between 0.005 m and 1 m, more preferably between 0.05 m and 0.5 m, more preferably still between 0.02 m and 0.2 m.

Each nozzle 105 comprises a swirl inducer 110 which is located at the inlet to the nozzle or between the nozzle inlet and the plasma-generating region (not shown in figure 2) of the nozzle. The swirl inducer 110 is adapted to encourage the feed gas to flow with a vortex motion. This vortex motion stabilises the plasma generated within the nozzle in such a way that it is sustained and remains in an ionised state as it flows into the reaction chamber 102. Accordingly, the plasma is reactive for some duration of its time in the reaction chamber 102. Ideally, the direction of rotation of each vortex flow within the nozzles is such that the vortex flow may positively contribute to the general stabilisation of the plasma within the reaction chamber.

A lower chamber 108, which may be used in separating reaction products, is located below the reaction chamber 102. For example, a solid product of the reaction may be separated in the lower chamber, as is explained below. It is desirable to establish a rotating fluid flow having a plane of rotation which is substantially horizontal to, or spiralling within, the reaction chamber and so the reaction chamber 102 with the adjoining lower chamber 108 preferably define a cyclone for the collection of solid particles. The solid product passes through a gas restricting valve 106, for example a rotary valve, to a lower output port 107.

An upper output port 101 is provided above the reaction chamber 102 and, in this embodiment of the invention, is used to collect gaseous reaction products (which are prevented from exiting via the lower output port 107 by the rotary valve 106).

Operation of the plasma reactor 100 will now be described with reference to Figure 2.

A feed supply of gas to be processed enters the manifold 104 through input channel 103 at a controlled pressure, typically between 1 and 2 bar abs. The flow rate of the feed gas is adjusted in accordance with various conditions of the reaction, for example: the energy of the plasma generator (i.e. the aforementioned apparatus of the plasma-generating region), the chemical composition of the feed gas, and the desired reaction outputs. For example, when a 6kW magnetron is used for plasma generation, gas flows may typically be set between 10 1/min to 100 1/min per nozzle.

From the manifold 104, the feed gas then flows through the multiple plasma nozzles 105. Within the plasma nozzles, the feed gas is first agitated to attain a stabilizing flow pattern, such as a vortex motion, by swirl inducers 110, and then excited to a plasma at the plasma-generating region. The result is a moving cloud of dissociated and/or partly dissociated gas, which continues in its flow pattern to the reaction chamber 102. The flow pattern of the plasma increases the stability of the plasma in the sense that the gases are maintained in the plasma state downstream of the plasma-generating region and into the reaction chamber 102. Such stabilisation allows the ionised gases to remain concentrated both after the plasma generator and within the reaction chamber, thereby extending the active region in which reactions can take place.

In the reaction chamber 102, the constituents of the dissociated gas may be separated or may be recombined to form other products, or may react with a substrate or other substance introduced to the chamber 102, depending on the specifics of the required reaction. Whichever reaction route is used, the products are extracted through an upper output port 101 or a lower output port 107.

The magnetrons in the embodiment described above are 6 kW magnetrons, but alternative magnetron sources of up to 100 kW or even greater still, depending upon availability, could be used. The magnetron may be of a type delivering a constant power, or it may be a pulsed magnetron which generates peak power values at specified intervals. For example, a 1 kW pulsed magnetron may be operated to generate power peaks of 10 kW at regular intervals. Hence, for the purposes of this description, references to magnetron power (kW) should be understood as electromagnetic energy, irrespective of whether the energy is generated by a pulsed magnetron or a constant-power magnetron. Higher fluid flow rates through the nozzles and in the reaction chamber will be preferred for higher values of electromagnetic energy.

Separating the plasma-generating regions from the reaction chamber has a two-fold effect. Firstly, the plasma output from the nozzles is additive. That is, each nozzle 105 feeds its plasma into the reaction chamber 102 and the volume of plasma in the reaction chamber is multiplied in proportion to the number of plasma nozzles used. Secondly, the reaction chamber is not limited in any way by the method with which plasma is generated, specifically the wavelength of microwaves that are responsible for its generation. This, in turn, means that the design of the plasma reactor is hugely flexible, enabling it to be readily adapted to the reaction that is taking place within. For example, a substrate can be introduced to the chamber either directly or via the plasma nozzles or gas flow can be used to entrain specific products.

In other operational modes, different feed materials can be introduced into various plasma nozzles around the reaction chamber. This enables the chamber conditions to be set to enable more complex reactions to take place. In the context of hydrogen generation, it would under certain circumstances be advantageous to introduce a carbon substrate into the chamber.

The above dimensions and values of parameters used for the reaction vessel are illustrative of one particular embodiment only and are not intended to be limiting. The system described is readily scaled-up. For example, the 6 kW magnetrons operating at 2450 MHz could be replaced by 1 kW to 30 kW magnetrons. Still larger magnetrons that are available of between 35 kW and 100 kW, operating at lower frequency, may be used with larger, upwards of 100 mm diameter, nozzles. The reaction chamber should be scaled up in size in proportion and according to the number of nozzles fitted.

Stabilisation of the plasma is an important feature of the separation of the plasma afterglow from its energising source as it enables the reactive phase of the feed gas to be maintained in the reaction chamber 102, remote from the plasma-generating region. A vortex motion, which is simply motion of the fluid in a roughly helical pattern, is known to form a relatively stable flow structure. This structure can be readily drawn through the plasma-generating region of the nozzles and the helical motion ensures an even distribution of feed gas exposed to the exciting source. The vortex should persist until such time as the plasma is comfortably within the reaction chamber 102. Obviously the actual time will depend on factors such as vortex velocity and initial gas flow.

In considering stabilisation, it is necessary to take account of the balance to be struck between fuelling the reaction that is taking place and forming the plasma. Increasing the flow through the plasma-generating region of the nozzles will transfer plasma faster, which in turn should reduce the need for vortex stabilisation. However, increased flow means increased energy demand on the apparatus for generating the plasma in providing energy for the ionisation, in order to avoid reducing the plasma density.

Alternative stabilisation methods are possible of course, although the vortex flow is preferred. It is simply required that an external force is applied to the flow in order to hold the plasma "cloud" in a particular shape, which is maintained as the plasma flows into the reaction chamber 102. For example a magnetic force may be used or a sonic flow. Magnetic forces are typically seen in the electron cyclotron resonance plasma source system typically employed in low pressure microwave plasma systems, prior art readily available.

Within the reaction chamber 102, the plasma cloud extends from the nozzles 105 and then adjacent the reaction chamber wall. This results in extended regions of plasma, distributed alongside the wall. Spacing between the nozzles around the reaction chamber determines the shape and intensity of the plasma cloud(s) within the chamber. In particular, each cloud emerging from its respective nozzle may merge with its neighbours to produce a continuous toroidal plasma zone located adjacent the wall of the reaction chamber.

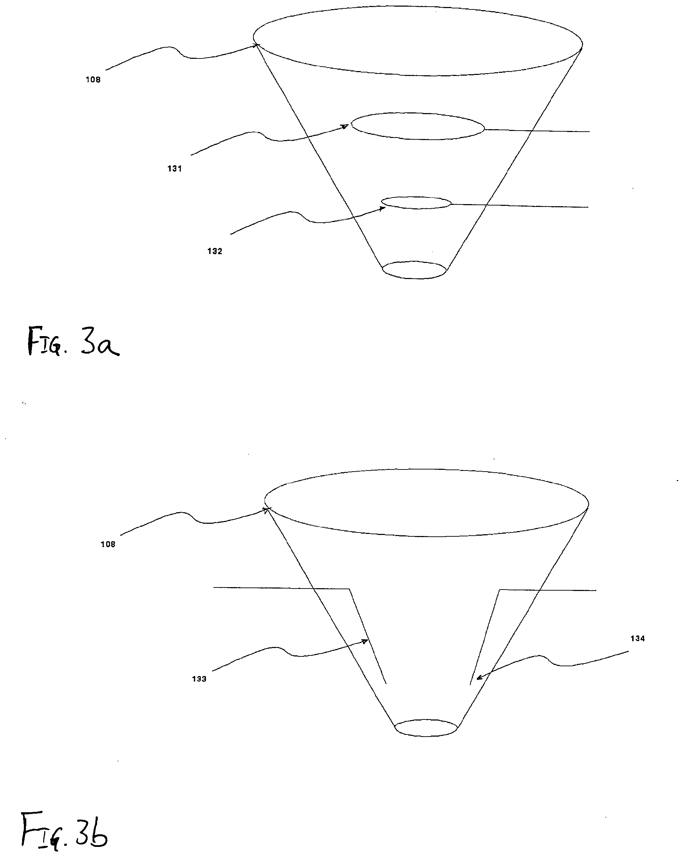

One practical application for which the plasma reactor is particularly suitable, is the production of hydrogen from a hydro-carbon gas, such as methane. Methane is fed into the manifold 104 and into the nozzles 105, from which it enters the reaction chamber 102 as a plasma, following the plasma-generating process described above. From the point that the plasma is generated, the reaction within the plasma to form dissociated carbon and hydrogen begins, and continues within the reaction chamber 102. Hydrogen gas is collected through the upper output port 101, from where it is fed to the post-processing module 3, as described above with reference to figure 1. In one embodiment, illustrated in figures 3a and 3b, one or more electrostatic plate or ring, connected to a suitable power supply (not shown), are placed in the lower chamber 108, in order to enhance the collection of dissociated carbon. Figure 3a illustrates two electrostatic rings 131, 132, while figure 3b shows two electrostatic plates 133, 134. The dissociated solid carbon is attracted to this plate or ring, on which it is accordingly deposited preferentially. The ring can be removed and replaced as necessary. The carbon is readily formed into products such as active carbon or carbon black. These carbon products are advantageous in comparison with currently available commercial products in that they are free from sulphur and oxygen impurities.

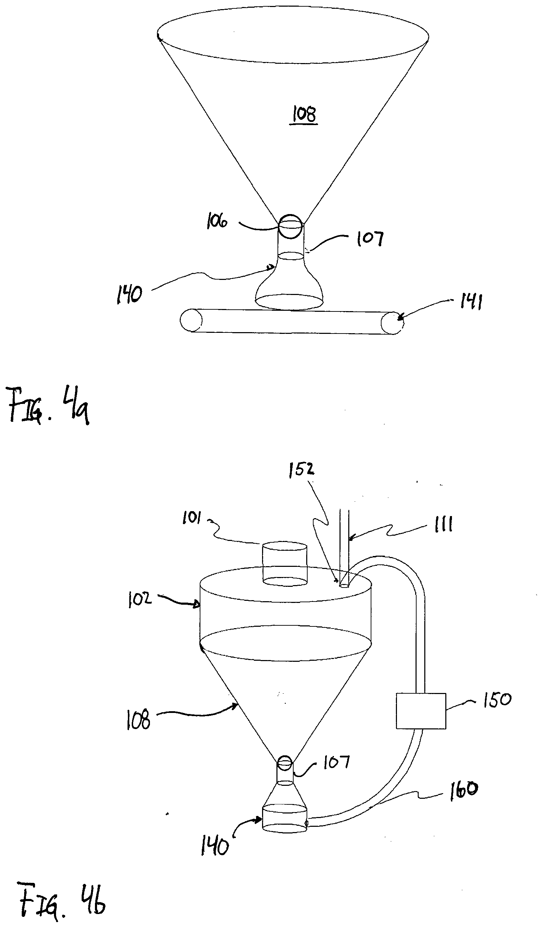

Figure 4a illustrates an alternative means for collecting the dissociated carbon, in the form of a powder precipitator 140 fluidly connected to the lower output port 107, and a powder collector 141 connected to the precipitator.

In one embodiment, the powder may be used as a reactant in the plasma, inasmuch as it is re-introduced into the reaction chamber 102. This is illustrated by figure 4b, showing a fluid line 160 at one end connected to the powder precipitator 140, via a pump 150, and at the other end to the reaction chamber 102 via the input port 111. The input port is preferably provided with a suitable nozzle, e.g. an eductor-type nozzle 152.

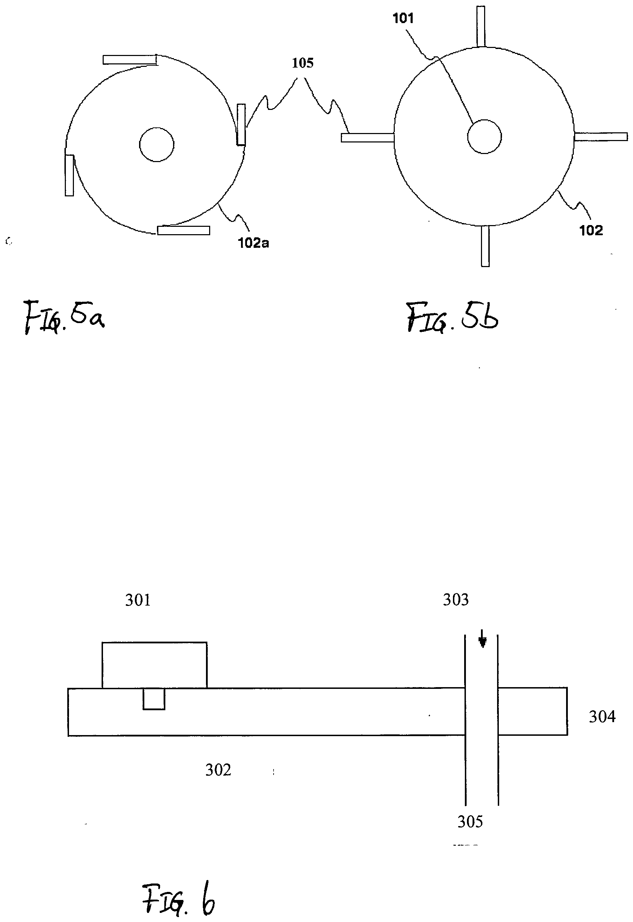

With reference now to Figures 5a and 5b, alternative orientations of plasma nozzles 105 with respect to the reaction chamber 102 are shown. In Figure 5a, the arrangement shown is a multiple-start spiral formation reaction chamber 102a. The vortex flow developed within the nozzle is, in this formation 102a, further encouraged in the reaction chamber 102. This can be beneficial for some processes. The alternative arrangement shown in Figure 5b provides a more axial flow in the reaction chamber 102. This is better suited for syngas formation as opposed to solid carbon formation, using the examples outlined above. It will be understood by one skilled in the art that nozzle configurations between these two extremes form a range of embodiments.

By virtue of the nozzle arrangement, fluid flow within the reaction chamber may be maintained. Under certain circumstances this flow may be sufficient to support a suspended belt of introduced particles, which may act as a substrate for one or more of the reaction products. Alternative means for sustaining fluid flow in the reaction chamber comprise mechanical mechanisms, a paddle type moving substrate, a forced flow of injected substrate particles or another jet that is not a plasma nozzle, a moving electromagnetic field influencing magnetic particles in suspension.

The reaction chamber 102 illustrated in this embodiment is toroidal in shape but it can alternatively be in the form of a sphere or cylinder, or other shape, preferably with curved walls.

In order to reduce or prevent the formation of carbon in the region of the nozzle outlet, the ratio of number of nozzles to reaction chamber diameter may be determined such that the nozzle outlets are optimally spaced with respect to one another around the reaction chamber circumference. Such nozzle spacing ratios typically lie between 1 and 30 nozzle diameters.

In the examples of Figures 5a and 5b, four plasma nozzles 105 are shown feeding into the reaction chamber 102, but this is for clarity of illustration only. Many more nozzles can be used, the limiting factor essentially being how many can be fitted around the chamber 102. It is also, of course, not essential for all nozzles to be used in generating plasma. For example, in a chamber with ten nozzles, perhaps only five may be used for plasma generation for one particular reaction. The remainder would be closed in order to prevent feed gases bypassing the plasma-generating regions of the active nozzles and entering the chamber. Alternatively, as described above with reference to figure 4b, nozzles not being used for plasma generation may be used to inject substrate particles or to inject gases (including gases from the output of the reaction chamber) thereby to supply reactants and / or to increase the kinetic energy within the reaction chamber.

As noted above, separation of the plasma generation from the reaction chamber is central to this invention, permitting the nozzles to make an additive contribution to plasma generation. Accordingly, the structure of these nozzles will now be described more fully with reference to Figures 6 to 9.

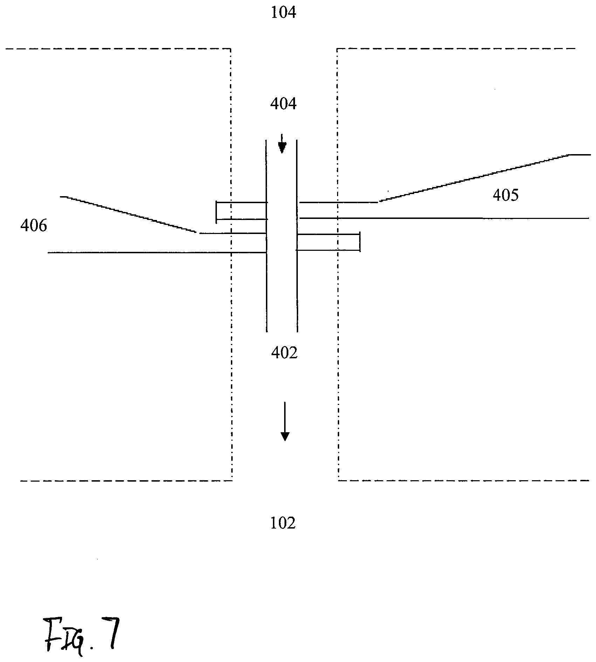

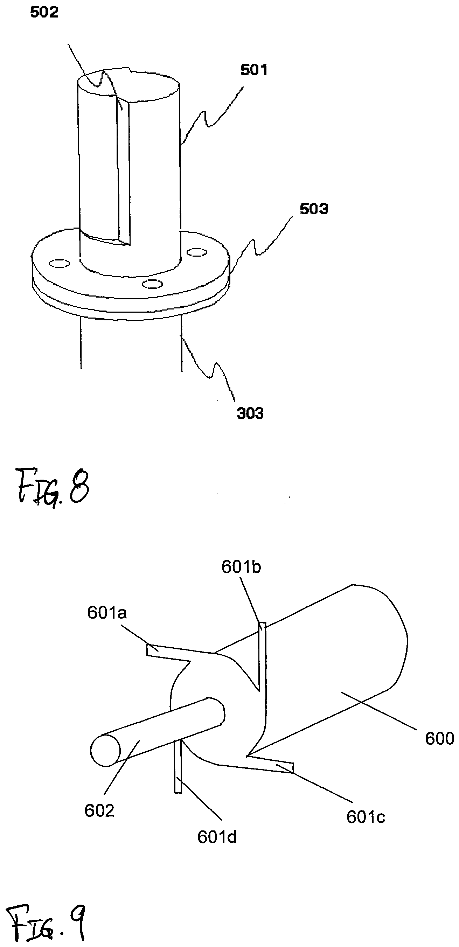

Figures 6 and 7 illustrate possible arrangements for the apparatus of the plasma-generating region, both based on microwave plasma generation. Figures 8 and 9 illustrate examples of the swirl inducers 110.

Turning first to Figure 6, there is shown a magnetron 301 and waveguide 302 configured as a plasma generator. The magnetron 301 is a conventional microwave generator structure, similar to the ones generally found in microwave ovens, generating an electromagnetic field (*E*-field) in a manner which is known in the art. In this arrangement a magnetron 301 feeds into a standard waveguide 302 with a closed end 304 forming a quarter wave stub. The magnetron may supply energy in the range 1 kW to 75kW. A suitable dielectric tube 303, for example a quartz tube, is located at a point where the *E*-field is a maximum, i.e. one quarter wavelength back from the closed end 304, such that the *E*-field intensity causes gas contained in the tube 303 to become ionised. Gas to be processed is fed into the tube 303 and flows from the intersection of the tube 303 with the waveguide 302 to an exit 305 in a dissociated state. An example of a suitable waveguide is the Surfaguide™ supplied by Sairem. The quartz tube 303 may equally be replaced by a tube of another material that is electrically insulating and with a low dielectric constant at the preferred frequency of operation.

A drawback associated with commercially available microwave sources, namely that they are low in power, is overcome in this invention in that the outputs from the individual plasma generators are added together. This advance is significant. The largest commercially available magnetrons are in the range 75 - 120 kW. Using a number of such magnetrons, say 10, oriented around a reaction chamber, a plasma zone of MW intensity can be generated.

The fluid passage of each nozzle is preferably straight and the nozzle diameter at the plasma-generating zone is preferably between 5 mm and 100 mm, more preferably between 10 mm and 50 mm, most preferably 30 mm to 40 mm for a 6 kW magnetron.

The microwave plasma generator employed in the plasma nozzle is preferably a coaxial magnetron. Furthermore, the microwaves generated and used in the plasma nozzles preferably have a device wavelength at between 0.01 m and 1 m, more preferably 0.05 m to 0.5 m, most preferably 0.1 m to 0.3 m. Also, the energy supplied to the microwave generator of each plasma nozzle is preferably between 0.1 kW and 500 kW, more preferably 0.5 kW to 120 kW, most preferably 1 kW to 75 kW.

The flow of material through the plasma nozzle preferably comprises a fluid, more preferably a gas. Furthermore, the flow through the plasma-generating zone of the plasma nozzle preferentially contains one or more reactants. Preferably, a major part, or ideally all, of at least one of the reactants flows through the plasma-generating zone. The reactants may constitute more than 50% of the flow through the plasma-generating zone, more preferably more than 75% of the flow and most preferably more than 90% of the flow.

The fluid fed to the plasma nozzle is preferably at a temperature of between -20 °C and +600 °C, more preferably 0 °C to 200 °C, most preferably 50 °C to 150 °C. The pressure within the plasma nozzle is preferably from 0.01 bar abs. to 8 bar abs., more preferably from 0.3 bar abs. to 5 bar abs., most preferably from 0.8 bar abs. to 3 bar abs. The volume of the plasma-generating region is preferably between 2x10⁻⁶ m³/kW and 10 x 10⁻⁶ m³/kW, more preferably 4 x 10⁻⁶ m³/kW - 10 x 10⁻⁶ m³/kW, most preferably 6 x 10⁻⁶ m³/kW - 10 x 10⁻⁶ m³/kW. Whereas, the average residence time within the plasma nozzle may be 10⁻⁶ seconds to 10⁻¹ seconds depending upon the material to be ionised.

As an example, the specific energy consumed to completely crack methane passing through the microwave plasma generator of the present invention at 100% efficiency is around 23 kJ/mol.

Whilst the volume of the reactor chamber will in each case be dependent upon the intended application and the processing requirements of the plasma reactor, in the case of a 2.45 GHz microwave plasma generator exemplary ranges of volumes are 10⁻³ m³ to 10³ m³, more preferably 10⁻² m³ to 10² m³, most preferably 1.5 m³ to 10² m³. However, the volume of the reaction chamber is preferably no less than 5 x 10⁻⁴ m³ per nozzle per kW but may extend upwards from this without limitation.

Furthermore, the residency time within the reaction chamber is dependent upon the reaction(s) occurring within the chamber and the desired output product but may extend from 0.1 seconds to several hours.

The arrangement shown in Figure 7 represents an improved plasma generator powered by two small magnetrons. The two magnetrons (not shown) are arranged to feed a common quartz tube 404 without interfering with each other or requiring elaborate phase and frequency locking systems. Each plasma nozzle of the reactor shown in Figure 2 may be of this type, in which case the reactor is capable of generating significantly more power than a reactor employing plasma nozzles of the type shown in Figure 6.

In Figure 7 two waveguides 405 and 406 are designed to taper such that the *E*-field intensifies in the region of the common quartz tube 404. Gas to be processed passes through the quartz tube 404 from the manifold 104 in the direction indicated by arrow 402 towards the reaction chamber 102. The gas first passes through a plasma-generating region produced by the magnetron waveguide 405 and then through a plasma-generating region formed by the magnetron waveguide 406. It is preferable for the two plasma-generating regions to be in close proximity, so that a single plasma cloud extending between the two plasma-generating regions is formed, which is not to say that the waveguides 405, 406 must be antiparallel, as shown in Figure 7. This orientation is shown for clarity only. With this arrangement, the intensity and the envelope (length) of generated plasma may be increased.

As stated previously, other designs of plasma generator are known in the art and are also suitable for use with this invention. Commercial-scale production, however, is likely to require a high throughput of feed gases and, as such, a plasma generator operating at or above atmospheric pressure is preferred. Microwaves are particularly effective generators of atmospheric plasma for fuel gas processing.

With reference to Figure 8, there is shown a first design of swirl inducer that is incorporated in the plasma nozzle 105 before the plasma-generating region. If used in combination with the generators shown in Figures 6 and 7, the swirl inducer is located in the quartz tube 303, 404 upstream of the plasma-generating regions. The purpose of the swirl inducer is to agitate the feed gas into a stabilising flow such as a vortex flow as it passes through the plasma zone. The swirl inducer comprises a number of slits 502 in a protrusion 501. A coupling flange 503, which may be externally cooled, allows for a flexible seal such that the quartz tube 303, 404 is not damaged as it shrinks and remains sealed as it expands, because temperature fluctuations are common during the plasma-generating process. Gas is driven under pressure into the protrusion 501 and forced to exit at the slits 502, which induces a generally helical flow pattern. The seal 503 prevents back flow to the manifold.

An alternative swirl inducer 110 is shown in Figure 9. This is based on a small version of a Hilsch tube, which is known to induce strong vortex motion in gas flow. Compressed gas is fed in tangentially to a larger diameter tube 600 along arms 601a, b, c, d. Gas exits in a vortex flow both from the larger diameter tube 600 and an adjoining smaller diameter tube 602. Gas from the smaller tube 602 has the stronger vortex flow and is then fed to the plasma-generating region. Gas exiting the larger tube 600 is re-circulated.

Alternative designs of swirl inducers are also envisaged, for example a spiral impeller, a Vortex tube arrangement or a simple fan arrangement. All that is important is that the feed gas is induced into a stabilizing flow before passing through the plasma-generating region of the nozzle. The purpose is two-fold. Firstly, to stabilise the plasma within the quartz tube 303, 404 and so to ensure that it persists into the reaction chamber. Secondly, to ensure that all feed gas passes through the plasma-generating region, which improves the uniformity of its processing.

It can be seen from the above description that many useful applications of a plasma reactor in accordance with this invention exist or may be developed. In particular, embodiments of the invention may be used to dissociate feed gases such as methane, natural gas and biogas with an efficiency not previously known. The dissociated products may be recombined so as to form clean fuels such as hydrogen gas and valued by-products such as high quality carbon black.

The invention is adaptable to many scales of operation. Small scale operation lends itself to distributed, on-demand fuel supplies such as hydrogen filling stations for future transport systems based upon hydrogen as a fuel. Alternatively, the invention could provide small domestic-scale systems that integrate with fuel cells to produce clean, environmentally-sound electricity and water. Large-scale operation lends itself to centralised clean hydrogen production systems.

Due to the additive nature of the multiple plasma nozzles which enables the plasma reactor of the present invention to be scaled up, it is possible for the plasma reactor to be retrofitted to existing flues and integrated into future flues of commercial scale industries.

Although the plasma reactor has been described principally in relation to the use of microwave plasma-generating sources, it is envisaged that the plasma reactor of the present invention may employ other types of plasma sources in combination with two or more microwave plasma nozzles. An example, of a non-microwave plasma source is as follows: three electrodes arranged in a plane such that they are equidistant from each other with a plasma-generating region lying in the plane of the three electrodes and equidistant there from. An electrically insulated tube of a suitable inert material, such as a ceramic, is arranged along an axis at 90 degrees to the plane of the three electrodes and intersecting that plane. The tube is used to contain a gas flow that flows across the plasma-generating region. A high voltage DC, AC (which may be 3 phase supply) or pulsed DC is applied to the electrodes such that an arc is discharged between the electrodes passing through apertures in the tube and thus across the plasma-generating zone. The arc ionises the gas flowing across the plasma-generating region between the electrodes, producing a plasma. The voltage applied to the electrodes must exceed the breakdown voltage of the gas flowing between the electrodes and the current may be limited by current control circuitry such that the power transferred into the plasma is controlled according to the desired reaction. When the supply is either AC or DC, the plasma is predominantly thermal, however when pulsed DC is used, a degree of non-equilibrium plasma is also produced. It will, of course, be apparent that the plasma generated may be stabilized using the same or similar techniques to those described above.

Referring again to figure 1, hydrogen gas generated by the plasma generator 100 is fed via a feed line 61 into a post-processing module 3, while produced carbon is conveyed into a reservoir 91 via suitable conduits 9.

In the post-processing unit 3, the produced hydrogen is first cooled using a heat exchanger / heat recovery unit (not shown), and then filtered (for example using electrostatic precipitation methods) before it is passed to a purification phase (for example comprising multi-stage palladium alloy diffusion cells) and then on to the storage and distribution module 5 via the conduit 81. Optionally, a fraction of the hydrogen may be routed back to the input port of the plasma reactor via return line 65. The post-processing unit 3 may also comprise an electrostatic precipitation unit (not shown in figure 1) in order to collect any residual carbon in the hydrogen stream. The captured carbon is fed into the carbon reservoir 91 via feed line 9.

Heat generated by the gas cooling process in the post-processing module 3 may optionally be recycled by the use of a heat exchanger (not shown). Optionally, extracted heat may be fed back to the pre-processing module 2 via conduit 64, (carrying a suitable heat-transport medium known in the art), where it may be used in the drying of the feed gas. The generated heat may (optionally) also be routed to the plasma reactor 100 (via the conduit 68) where it advantageously may be used to pre-heat the feed gas before entering the plasma-generating region.

The storage and distribution module 5 comprises a compressor 83 and booster 84, a storage vessel 82, interconnected by lines 81a, and an output facility 85 from which the generated hydrogen may be provided to a consumer via outlet 81b, as shown in figure 1.

Changes to the plasma reactor other than those described above are envisaged without departing scope of the invention as defined in the claims appended hereto.

## Claims

1. A system for producing hydrogen from gaseous hydrocarbon, **characterised by** a gas pre-treatment module (2) fluidly connected to a gas reservoir (66) and to at least one hydrogen generator (100); and a hydrogen post-processing module (3) fluidly connected via a feeding conduit (81) to the generator and to a storage and distribution module (5), said hydrogen generator comprising plasma nozzles (105); a reaction chamber (102) coupled to each of the plasma nozzles; each plasma nozzle comprising a microwave plasma generator (301, 302) and a feed tube (303) for directing a flow of the gaseous hydrocarbon via the plasma generator to respective inlets to the reaction chamber, whereby the microwave plasma generator is suitable for at least partly ionising the gaseous hydrocarbon to form a plasma prior to entry of the at least partly ionised hydrocarbon into the reaction chamber, and the reaction chamber comprises at least one outlet (101) via which hydrogen is conveyed to the post-processing module (3), and the pre-treatment module (2) comprises means for pre-heating the gaseous hydrocarbon.

2. The system of claim 1, wherein the post-processing module (3) comprises means for cooling the hydrogen, preferably a heat exchanger.

3. The system of claim 1 or 2, further comprising a feed-back conduit (65) fluidly connected to the feeding conduit (81) and adapted for feeding at least a portion of the hydrogen back to hydrogen generator.

4. The system of any one of claims 1 - 3, wherein the storage and distribution module (5) comprises hydrogen compressor (83) and boosting (84) means, hydrogen storage means (82) and hydrogen output means (85).

5. The system of any one of claims 1 - 4, further comprising a carbon reservoir (91), connected via a conduit (9) to the hydrogen generator (100).

6. A method of producing hydrogen from a gas comprising hydrocarbon, **characterised by** the steps of:
a) feeding separate quantities of the gas at a controlled pressure to respective regions where each quantity of gas is subjected to a respective electromagnetic field, whereby a non-equilibrium plasma at atmospheric pressure and above is generated in each region;
b) feeding the separate quantities of plasma into a reaction chamber (102) via separate inlets while controlling the flow properties of the plasma in order to sustain the plasma and maintain it in an ionised state until it enters the reaction chamber and for a duration of time thereafter; and
c) extracting produced hydrogen via an outlet (101) from the reaction chamber, whereby hydrogen may be produced virtually on demand, continuously and without the generation of oxides of carbon, and the respective plurality of electromagnetic fields are generated by separate and individual microwave sources, and
d) extracting precipitated carbon from the reaction chamber.

7. The method of claim 6, further comprising the mixing of said separate quantities of plasma in the reaction chamber while the plasmas are in an ionised state.

8. The method of claim 6 or 7, wherein the controlling of the flow properties of the plasma in step b) comprises forming a vortex gas flow before the gas enters the plasma state.

9. The method of any of claims 7 - 9, further comprising the introduction of a substrate in particulate form into the plasma in the reaction chamber.

10. The method of claim 9, wherein said substrate comprises precipitated carbon extracted from the reaction chamber.

## Patentansprüche

1. System zur Herstellung von Wasserstoff aus gasförmigem Kohlenwasserstoff, **gekennzeichnet durch** ein Gasvorbehandlungsmodul (2), das in Fluidverbindung mit einem Gasreservoir (66) und mit wenigstens einem Wasserstoffgenerator (100) ist; und ein Wasserstoff-Nachbearbeitungsmodul (3), das über eine Zuführungsleitung (81) in Fluidverbindung mit dem Generator und einem Speicher- und Verteilungsmodul (5) ist, wobei der Wasserstoffgenerator Plasmadüsen (105) umfasst; eine Reaktionskammer (102), die mit jeder der Plasmadüsen gekoppelt ist; wobei jede Plasmadüse einen Mikrowellen-Plasmagenerator (301, 302) und ein Zuführungsrohr (303), um einen Strom des gasförmigen Kohlenwasserstoffs durch den Plasmagenerator zu jeweiligen Einlässen in die Reaktionskammer zu leiten, umfasst, wobei der Mikrowellen-Plasmagenerator für ein wenigstens teilweises Ionisieren des gasförmigen Kohlenwasserstoffs unter Bildung eines Plasmas vor Eintritt des wenigstens teilweise ionisierten Kohlenwasserstoffs in die Reaktionskammer geeignet ist, und die Reaktionskammer wenigstens einen Auslass (101) umfasst, durch den Wasserstoff zu dem Nachbearbeitungsmodul (3) transportiert wird, und das Vorbehandlungsmodul (2) Mittel zum Vorerwärmen des gasförmigen Kohlenwasserstoffs umfasst.

2. System nach Anspruch 1, wobei das Nachbearbeitungsmodul (3) Mittel zum Kühlen des Wasserstoffs, vorzugsweise einen Wärmetauscher, umfasst.

3. System nach Anspruch 1 oder 2, das ferner eine Rückführungsleitung (65), die in Fluidverbindung mit der Zuführungsleitung (81) ist und zur Zurückführung wenigsten eines Teils des Wasserstoffs zu dem Wasserstoffgenerator angepasst ist, umfasst.

4. System nach einem der Ansprüche 1-3, wobei das Speicher- und Verteilungsmodul (5) Wasserstoffkompressor (83)- und - Boosting (84)-Mittel, Wasserstoff-Speichermittel (82) und Wasserstoff-Ausgabemittel (85) umfasst.

5. System nach einem der Ansprüche 1-4, das ferner ein Kohlenstoffreservoir (91) umfasst, das über eine Leitung (9) mit dem Wasserstoffgenerator (100) verbunden ist.

6. Verfahren zur Herstellung von Wasserstoff aus einem Gas, das Kohlenwasserstoff umfasst, **gekennzeichnet durch** die Schritte:
a) Zuführen getrennter Mengen des Gases mit einem kontrollierten Druck zu jeweiligen Regionen, wo jede Gasmenge einem jeweiligen elektromagnetischen Feld ausgesetzt wird, wodurch in jeder Region ein Nicht-Gleichgewichts-Plasma bei Atmosphärendruck und darüber erzeugt wird;
b) Zuführen der getrennten Plasmamengen durch getrennte Einlässe in eine Reaktionskammer (102), während die Fließeigenschaften des Plasmas kontrolliert werden, um das Plasma aufrecht zu erhalten und es in einem ionisierten Zustand zu halten, bis es in die Reaktionskammer eintritt und für eine Zeitdauer danach; und
c) Entnehmen von hergestelltem Wasserstoff über einen Auslass (101) aus der Reaktionskammer, wobei Wasserstoff praktisch auf Verlangen, kontinuierlich und ohne die Erzeugung von Kohlenstoffoxiden hergestellt werden kann und die jeweilige Vielzahl elektromagnetischer Felder durch getrennte und individuelle Mikrowellenquellen erzeugt wird, und
d) Entnehmen von präzipitiertem Kohlenstoff aus der Reaktionskammer.

7. Verfahren nach Anspruch 6, das ferner Mischen der getrennten Plasmamengen in der Reaktionskammer, während die Plasmen in einem ionisierten Zustand sind, umfasst.

8. Verfahren nach Anspruch 6 oder 7, wobei das Kontrollieren der Fließeigenschaften des Plasmas in Schritt b) Bilden einer Wirbelgasströmung, bevor das Gas in den Plasmazustand eintritt, umfasst.

9. Verfahren nach einem der Ansprüche 7-9, das ferner die Einführung eines Substrates in partikulärer Form in das Plasma in der Reaktionskammer umfasst.

10. Verfahren nach Anspruch 9, wobei das Substrat präzipitierten Kohlenstoff, der aus der Reaktionskammer entnommen worden war, umfasst.

## Revendications

1. Système de production d'hydrogène à partir d'hydrocarbures gazeux, **caractérisé par** un module de prétraitement de gaz (2) relié de manière fluidique à un réservoir de gaz (66) et à au moins un générateur d'hydrogène (100) ; et un module de post-traitement d'hydrogène (3) relié de manière fluidique par un conduit d'alimentation (81) au générateur et à un module de stockage et de distribution (5), ledit générateur d'hydrogène comprenant des buses à plasma (105) ; une chambre de réaction (102) couplée à chacune des buses à plasma ; chaque buse à plasma comprenant un générateur de plasma à micro-ondes (301, 302) et un tube d'alimentation (303) pour orienter un flux d'hydrocarbures gazeux via le générateur de plasma vers des entrées respectives de la chambre de réaction, système selon lequel le générateur de plasma à micro-ondes convient pour ioniser au moins partiellement les hydrocarbures gazeux pour former un plasma avant l'entrée des hydrocarbures au moins partiellement ionisés dans la chambre de réaction, et la chambre de réaction comprend au moins une sortie (101) par laquelle de l'hydrogène est acheminé vers le module de post-traitement (3), et le module de prétraitement (2) comprend des moyens pour préchauffer les hydrocarbures gazeux.

2. Système selon la revendication 1, dans lequel le module de post-traitement (3) comprend des moyens pour refroidir l'hydrogène, de préférence un échangeur thermique.

3. Système selon la revendication 1 ou 2, comprenant en outre un conduit de retour (65) relié de manière fluidique au conduit d'alimentation (81) et adapté pour renvoyer au moins une partie de l'hydrogène au générateur d'hydrogène.

4. Système selon l'une quelconque des revendications 1 à 3, dans lequel le module de stockage et de distribution (5) comprend un compresseur d'hydrogène (83) et des moyens de surpression *(« boosting means* ») (84), des moyens de stockage d'hydrogène (82) et des moyens de sortie d'hydrogène (85) .

5. Système selon l'une quelconque des revendications 1 à 4, comprenant en outre un réservoir de carbone (91), relié par un conduit (9) au générateur d'hydrogène (100).

6. Procédé de production d'hydrogène à partir d'un gaz comprenant des hydrocarbures, **caractérisé par** les étapes :
a) de fourniture de quantités distinctes du gaz à une pression contrôlée à des zones respectives dans lesquelles chaque quantité de gaz est soumise à un champ électromagnétique respectif, moyennant quoi un plasma non équilibré à la pression atmosphérique et au-dessus de celle-ci est généré dans chaque zone ;
b) de fourniture de quantités distinctes de plasma à une chambre de réaction (102) par des entrées distinctes tout en contrôlant les propriétés d'écoulement du plasma afin d'entretenir le plasma et de le maintenir dans un état ionisé jusqu'à ce qu'il pénètre dans la chambre de réaction et pendant une certaine durée par la suite ; et
c) d'extraction de l'hydrogène produit par une sortie (101) de la chambre de réaction, moyennant quoi de l'hydrogène peut être produit quasiment à la demande, en continu et sans générer d'oxydes de carbone, et la pluralité respective de champs électromagnétiques est générée par des sources de micro-ondes distinctes et individuelles, et
d) d'extraction du carbone précipité de la chambre de réaction.

7. Procédé selon la revendication 6, comprenant en outre le mélange desdites quantités distinctes de plasma dans la chambre de réaction pendant que les plasmas sont dans un état ionisé.

8. Procédé selon la revendication 6 ou 7, dans lequel le contrôle des propriétés d'écoulement du plasma dans l'étape b) comprend la formation d'un écoulement de gaz tourbillonaire avant que le gaz passe à l'état de plasma.

9. Procédé selon l'une quelconque des revendications 7 à 9, comprenant en outre l'introduction d'un substrat sous forme particulaire dans le plasma dans la chambre de réaction.

10. Procédé selon la revendication 9, dans lequel ledit substrat comprend du carbone précipité extrait de la chambre de réaction.
